# EUROPEAN PATENT APPLICATION

(11) **EP 4 814 161 A1**
(43) Date of publication of application: **30.09.2026**
(21) Application number: 25224649.1
(22) Date of filing: 17.12.2025
(51) Int. Cl.: C23C 16/448, C23C 16/455

(54) **GAS SUPPLY METHOD, METHOD OF MANUFACTURING SEMICONDUCTOR DEVICE, GAS SUPPLY SYSTEM, SUBSTRATE PROCESSING APPARATUS AND PROGRAM**

(30) Priority: 31.01.2025 JP 2025015391
(71) Applicant: Kokusai Electric Corp., Tokyo 100-0004 (JP)
(72) Inventor: NAKATANI, Shunsuke, Toyama-shi, 939-2393 (JP); GOSHIMA, Kentaro, Toyama-shi, 939-2393 (JP)
(74) Representative: Verscht, Thomas Kurt Albert

(57) **Abstract**

It is possible to stably supply a gas obtained by gasifying a material to a process chamber. There is provided a technique that includes: (a) exhausting a process gas containing a specified gas obtained by gasifying a material stored in a container such that the process gas is exhausted without passing through a process chamber; and (b) supplying the process gas to the process chamber, wherein a cycle comprising at least (b) is performed a plurality of times, and wherein, in a first execution of the cycle, (b) is performed by switching from (a) when a flow rate of the specified gas reaches a saturated state.

## Description

### [Technical Field]

The present disclosure relates to a gas supply method, a method of manufacturing a semiconductor device, a gas supply system, a substrate processing apparatus and a program.

### [Related Art]

As an example of a substrate processing apparatus, a semiconductor manufacturing apparatus may be used to manufacture a semiconductor device. For example, using the substrate processing apparatus, a substrate processing of processing a substrate by supplying a process gas may be performed. In recent years, for example, due to a miniaturization of a device such as the semiconductor device, various gases (such as a gas obtained by vaporizing a liquid material and a gas obtained by sublimating a solid material) may be used as the process gas. Therefore, it is preferable to stably supply the process gas. For example, according to Patent Document 1, the process gas may be supplied to a process chamber of the substrate processing apparatus at a controlled flow rate by using a plurality of containers.

### [Related Art Document]

### [Patent Document]

Patent Document 1: Japanese Patent Laid-Open No. 2025-000487.

### [Disclosure]

### [Technical Problem]

According to the present disclosure, there is provided a technique capable of stably supplying a gas obtained by gasifying a material to a process chamber.

### [Technical Solution]

According to an embodiment of the present disclosure, there is provided a technique that includes: (a) exhausting a process gas containing a specified gas obtained by gasifying a material stored in a container such that the process gas is exhausted without passing through a process chamber; and (b) supplying the process gas to the process chamber, wherein a cycle comprising at least (b) is performed a plurality of times, and wherein, in a first execution of the cycle, (b) is performed by switching from (a) when a flow rate of the specified gas reaches a saturated state.

### [Advantageous Effects]

According to some embodiments of the present disclosure, it is possible to stably supply a gas obtained by gasifying a material to a process chamber.

### [Brief Description of Drawings]

FIG. 1 is a diagram schematically illustrating a vertical cross-section of a process furnace of a substrate processing apparatus according to one or more embodiments of the present disclosure.
FIG. 2 is a diagram schematically illustrating a horizontal cross-section of the process furnace, taken along a line A - A shown in FIG. 1.
FIG. 3 is a diagram schematically illustrating peripheral structures of the process furnace of the substrate processing apparatus according to the embodiments of the present disclosure.
FIG. 4 is a diagram schematically illustrating a gas supply system of the substrate processing apparatus according to the embodiments of the present disclosure.
FIG. 5 is a block diagram schematically illustrating a configuration of a controller and related components of the substrate processing apparatus according to the embodiments of the present disclosure.
FIG. 6 is a diagram schematically illustrating a relationship between a flow rate of each gas and time in the gas supply system of the substrate processing apparatus according to the embodiments of the present disclosure.
FIG. 7A is a diagram schematically illustrating a relationship between a flow rate of a source gas and time in the gas supply system of the substrate processing apparatus according to the embodiments of the present disclosure.
FIG. 7B is another diagram schematically illustrating the relationship between the flow rate of the source gas and time in the gas supply system of the substrate processing apparatus according to the embodiments of the present disclosure.
FIG. 8A is a diagram schematically illustrating an exhaust state of a process gas in the gas supply system of the substrate processing apparatus according to the embodiments of the present disclosure.
FIG. 8B is a diagram schematically illustrating a supply state of the process gas in the gas supply system of the substrate processing apparatus according to the embodiments of the present disclosure.
FIG. 9 is a diagram schematically illustrating a relationship between a flow rate of each gas and time in a gas supply system according to a modified example.

### [Detailed Description]

### <Embodiments of Present Disclosure>

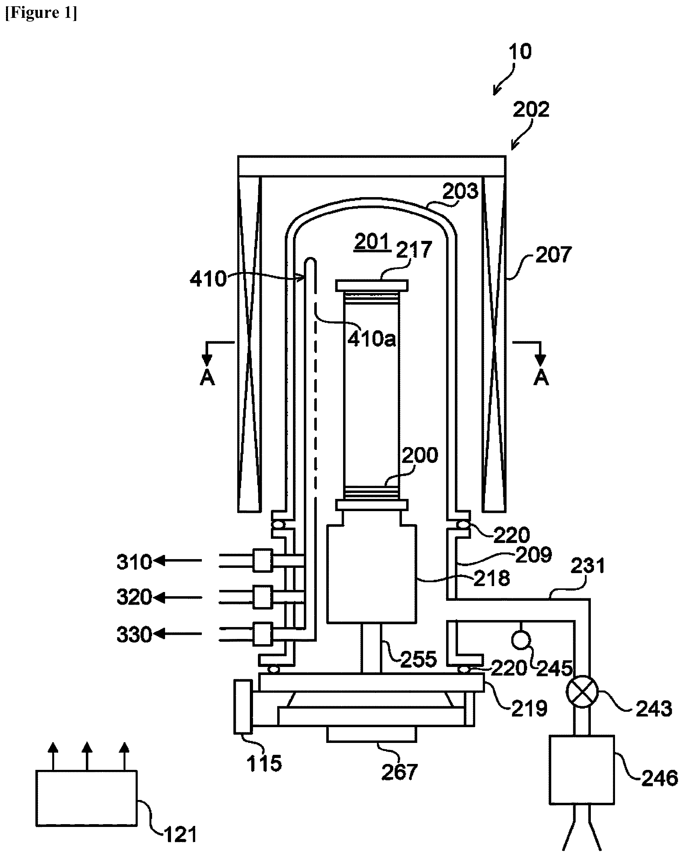

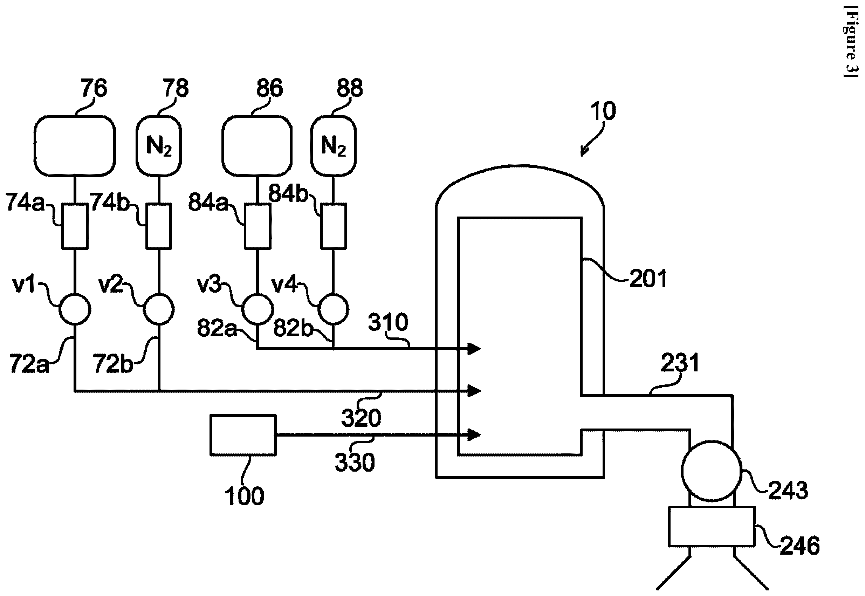

Hereinafter, one or more embodiments (hereinafter, also simply referred to as "embodiments") according to the present disclosure will be described with reference to FIGS. 1 to 8B. For example, the drawings used in the following descriptions are all schematic, and a relationship between dimensions of each component and a ratio of each component shown in the drawing may not always match the actual ones. In addition, even between the drawings, the relationship between the dimensions of each component and the ratio of each component may not always match.

FIG. 1 is a diagram schematically illustrating a vertical cross-section of a process furnace 202 of a substrate processing apparatus 10 according to the embodiments of the present disclosure.

As shown in FIG. 1, the process furnace 202 is provided with a heater 207 serving as a heating structure (which is a heating apparatus). The heater 207 is of a cylindrical shape, and is supported by a heater base (not shown).

A reaction tube 203 constituting a reaction vessel (process vessel) is provided in an inner side of the heater 207 to be aligned in a manner concentric with the heater 207. For example, the reaction tube 203 is made of a heat resistant material such as quartz (SiO₂) and silicon carbide (SiC). For example, the reaction tube 203 is of a cylindrical shape with a closed upper end and an open lower end. A process chamber 201 is configured to be capable of accommodating a plurality of wafers 200 in a horizontal orientation to be vertically arranged (aligned) in a multistage manner by a boat 217 described later. Hereinafter, each of the plurality of wafers 200 may also be simply referred to as a "wafer 200" serving as a substrate.

For example, a manifold 209 made of a metal material is provided below the reaction tube 203 so as to support the reaction tube 203. Nozzles 410, 420 and 430 are installed in the process chamber 201 so as to penetrate a side wall of the manifold 209. Gas supply pipes 310, 320 and 330 serving as gas supply lines are connected to the nozzles 410, 420 and 430, respectively. In a manner described above, the three nozzles 410, 420 and 430 and the three gas supply pipes 310, 320 and 330 are provided at the reaction tube 203 (that is, the manifold 209). Thereby, it is possible to supply various gases (process gases) into the process chamber 201 through the three gas supply pipes 310, 320 and 330 and the three nozzles 410, 420 and 430. Hereinafter, the gas supply pipe 310 may also be referred to as a "first gas supply pipe 310", the gas supply pipe 320 may also be referred to as a "second gas supply pipe 320", and the gas supply pipe 330 may also be referred to as a "third gas supply pipe 330". In addition, the nozzle 410 may also be referred to as a "first nozzle 410", the nozzle 420 may also be referred to as a "second nozzle 420", and the nozzle 430 may also be referred to as a "third nozzle 430".

However, the process furnace 202 of the present embodiments is not limited to the example described above. For example, the nozzles 410, 420 and 430 may be installed so as to penetrate a side wall of the reaction tube 203. In such a case, an exhaust pipe 231 described later may be provided at the side wall of the reaction tube 203, or may be provided at the side wall of the manifold 209 (see FIG. 1). In a manner described above, a furnace opening of the process furnace 202 may be defined by a structure made of a metal material, and components such as the nozzles 410, 420 and 430 may be installed at the structure made of the metal material. Hereinafter, the present embodiments will be described by way of an example in which the exhaust pipe 231 is provided at the reaction tube 203.

The process gases are supplied through the gas supply pipes 310, 320 and 330 (that is, the first gas supply pipe 310, the second gas supply pipe 320 and the third gas supply pipe 330) and the nozzles 410, 420 and 430, respectively. Hereinafter, each of the process gases may also be referred to as a "process gas".

According to the present embodiments, as the process gas, for example, an oxygen-containing gas serving as a reactive gas (reactant) containing oxygen (O) may be used, or a nitrogen-containing gas serving as a reactive gas (reactant) containing nitrogen (N) may be used. As the nitrogen-containing gas, for example, a nitrogen-containing gas free of a metal element may be used.

As the process gas, for example, a source gas in a gaseous state obtained by vaporizing a source martial (liquid source material) in a liquid state at a normal temperature (room temperature) and a normal pressure may be used, or a source gas (hereinafter, also referred to as a "precursor gas") in a gaseous state obtained by sublimating a source martial (solid source material) in a solid state at the normal temperature and the normal pressure may be used. That is, the source martial and the source gas according to the present embodiments serve as an example of a martial of the present disclosure and an example of a gas obtained by gasifying the material of the present disclosure, respectively.

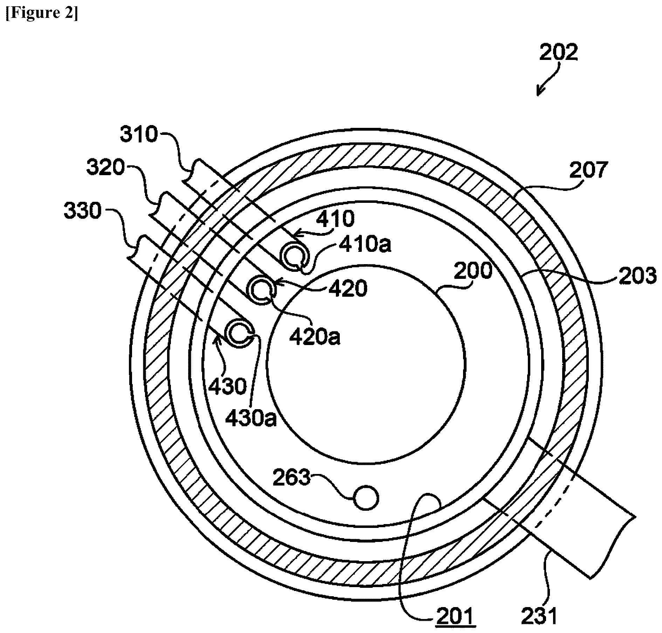

As shown in FIGS. 1 and 2, the nozzles 410, 420 and 430 are connected to front ends (tips) of the gas supply pipes 310, 320 and 330, respectively. Horizontal portions of the nozzles 410, 420 and 430 are provided so as to penetrate the side wall of the manifold 209. Vertical portions of the nozzles 410, 420 and 430 are provided in an annular space provided between an inner wall of the reaction tube 203 and the wafers 200 when viewed from above, and extend upward along the inner wall of the reaction tube 203 (that is, extends upward along a stacking direction of the wafers 200).

A plurality of gas supply holes 410a, a plurality of gas supply holes 420a and a plurality of gas supply holes 430a are provided at side surface of the nozzles 410, 420 and 430, respectively. Gases are provided (ejected) through the gas supply holes 410a, the gas supply holes 420a and the gas supply holes 430a, respectively. The gas supply holes 410a, the gas supply holes 420a and the gas supply holes 430a are open toward a center of the reaction tube 203. The gas supply holes 410a, the gas supply holes 420a and the gas supply holes 430a are provided from a lower portion to an upper portion of the reaction tube 203. Hereinafter, the gas supply holes 410a may also be referred to as "first gas supply holes 410a", the gas supply holes 420a may also be referred to as "second gas supply holes 420a", and the gas supply holes 430a may also be referred to as "third gas supply holes 430a".

According to the present embodiments, the gases are respectively supplied through the nozzles 410, 420 and 430 (which are provided in the annular space defined by the inner wall of the reaction tube 203 and edges (peripheries) of the wafers 200 arranged in the reaction tube 203). Then, the gases are respectively ejected into the reaction tube 203 through the gas supply holes 410a, the gas supply holes 420a and the gas supply holes 430a, respectively. Each of the gases ejected into the reaction tube 203 mainly flows in a direction parallel to surfaces of the wafers 200, that is, in a horizontal direction. After flowing over the surfaces of the wafers 200, the gas (for example, a residual gas remaining after the reaction) flows toward an exhaust port, that is, toward the exhaust pipe 231 described later.

The exhaust pipe 231 through which an atmosphere (inner atmosphere) of the process chamber 201 is exhausted is provided at the reaction tube 203. A vacuum pump 246 serving as a vacuum exhaust apparatus is connected to the exhaust pipe 231 through a pressure sensor 245 and an APC (Automatic Pressure Controller) valve 243. The pressure sensor 245 serves as a pressure detector (pressure detection structure) configured to detect a pressure (inner pressure) of the process chamber 201, and the APC valve 243 serves as a pressure regulator (pressure adjusting structure). With the vacuum pump 246 serving as the vacuum exhaust apparatus in operation, the APC valve 243 is configured to be capable of being opened or closed to perform a vacuum exhaust operation for the process chamber 201 or stop the vacuum exhaust operation. In addition, with the vacuum pump 246 in operation, the APC valve 243 is configured to be capable of adjusting the inner pressure of the process chamber 201 by adjusting an opening degree of the APC valve 243 based on pressure information detected by the pressure sensor 245. An exhauster (which is an exhaust structure) is constituted mainly by the exhaust pipe 231, the APC valve 243 and the pressure sensor 245. The exhauster may further include the vacuum pump 246.

A furnace opening lid 219 capable of airtightly sealing (or closing) a lower end opening of the reaction tube 203 is provided under the reaction tube 203. The furnace opening lid 219 is provided to be brought into contact with the lower end of the reaction tube 203 from thereunder in a vertical direction. For example, the furnace opening lid 219 is made of a metal material such as SUS, and is of a disk shape. An O-ring 220 serving as a seal is provided on an upper surface of the furnace opening lid 219 so as to be in contact with the lower end of the reaction tube 203.

A rotator (which is a rotating structure) 267 configured to rotate the boat 217 described later is provided at the furnace opening lid 219 in a manner opposite to the process chamber 201. A rotating shaft 255 of the rotator 267 is connected to the boat 217 penetrating the furnace opening lid 219. The rotator 267 is configured to rotate the wafers 200 by rotating the boat 217. The furnace opening lid 219 is configured to be elevated or lowered in the vertical direction by a boat elevator 115 serving as an elevating structure vertically provided outside the reaction tube 203. By elevating and lowering the furnace opening lid 219, the boat elevator 115 is configured to be capable of transferring (loading) the boat 217 into the process chamber 201 and capable of transferring (unloading) the boat 217 out of the process chamber 201.

The boat 217 serving as a substrate support (substrate retainer) is configured to accommodate (or support) the wafers 200 (for example, from 25 wafers to 200 wafers) while the wafers 200 are horizontally oriented with their centers aligned with one another with a predetermined interval therebetween in the vertical direction in a multistage manner. For example, the boat 217 is made of a heat resistant material such as quartz and SiC. A plurality of heat insulating plates 218 horizontally oriented are provided under the boat 217 in a multistage manner. For example, each of the heat insulating plates 218 is made of a heat resistant material such as quartz and SiC. With such a configuration, the heat insulating plates 218 suppress a transmission of the heat from the heater 207 to the furnace opening lid 219. However, the present embodiments are not limited thereto. For example, instead of the heat insulating plates 218, a heat insulating cylinder (not shown) such as a cylinder made of a heat resistant material such as quartz and SiC may be provided under the boat 217.

A temperature sensor 263 (see FIG. 2) serving as a temperature detector is installed in the reaction tube 203. An amount of electric current supplied (or applied) to the heater 207 is adjusted based on temperature information detected by the temperature sensor 263 such that a desired temperature distribution of a temperature (inner temperature) of the process chamber 201 can be obtained. Similar to the nozzles 410, 420 and 430, the temperature sensor 263 may be L-shaped, and may be provided along the inner wall of the reaction tube 203.

Subsequently, peripheral structures of the process furnace 202 of the substrate processing apparatus 10 will be described. The first gas supply pipe 310, the second gas supply pipe 320 and the third gas supply pipe 330 are provided at the process chamber 201.

The first gas supply pipe 310 branches into first branch pipes 82a and 82b at an upstream side of the first gas supply pipe 310. For example, an oxidizing gas supply source 86 configured to supply an oxygen gas serving as a first source gas is connected to the first branch pipe 82a through a valve v3 and an MFC (Mass Flow Controller) 84a serving as a flow rate controller. For example, a first inert gas supply source 88 to supply an inert gas (such as nitrogen (N₂)) serving as a first inert gas is connected to the first branch pipe 82b through a valve v4 and an MFC 84b. Hereinafter, when simply referring to the first branch pipes 82a and 82b branching off from the first gas supply pipe 310, the first branch pipes 82a and 82b may be collectively or individually referred to as a "first branch pipe 82". In addition, when simply referring to the MFCs 84a and 84b provided at the first branch pipe 82, the MFCs 84a and 84b may be collectively or individually referred to as a "MFC 84". The same may also apply to other components described later.

With such a configuration, the first source gas serving as a first reactive gas (or a gaseous mixture of the first source gas and the inert gas such as the N₂) is introduced (supplied) into the process chamber 201 through the first gas supply pipe 310. For example, a first source gas supplier (which is a first source gas supply structure) is constituted mainly by the first gas supply pipe 310, the first branch pipe 82a, the valve v3, the MFC 84a, and the oxidizing gas supply source 86.

The second gas supply pipe 320 branches into second branch pipes 72a and 72b at an upstream side of the second gas supply pipe 320. For example, a nitriding gas supply source 76 configured to supply a nitriding gas serving as a second source gas is connected to the second branch pipe 72a through a valve v1 and an MFC 74a. For example, a second inert gas supply source 78 to supply an inert gas (such as nitrogen (N₂)) serving as a second inert gas is connected to the second branch pipe 72b through a valve v2 and an MFC 74b. Hereinafter, when simply referring to the second branch pipes 72a and 72b branching off from the second gas supply pipe 320, the second branch pipes 72a and 72b may be collectively or individually referred to as a "second branch pipe 72". In addition, when simply referring to the MFCs 74a and 74b provided at the second branch pipe 72, the MFCs 74a and 74b may be collectively or individually referred to as a "MFC 74".

With such a configuration, the second source gas serving as a second reactive gas (or a gaseous mixture of the second source gas and the inert gas such as the N₂) is introduced (supplied) into the process chamber 201 through the second gas supply pipe 320. For example, a second source gas supplier (which is a second source gas supply structure) is constituted mainly by the second gas supply pipe 320, the second branch pipe 72a, the valve v1, the MFC 74a, and the nitriding gas supply source 76.

In the first source gas supplier and the second source gas supplier, the inert gas respectively supplied from the first inert gas supply source 88 and the second inert gas supply source 78 may be used. The inert gas may act as a purge gas, a dilution gas or a carrier gas in a substrate processing described later. In addition, the first gas supply pipe 310, the second gas supply pipe 320 and the third gas supply pipe 330 may be provided with exhaust pipes through which the gases are discharged outward, respectively. In addition, the exhaust pipe provided on the third gas supply pipe 330 will be described later.

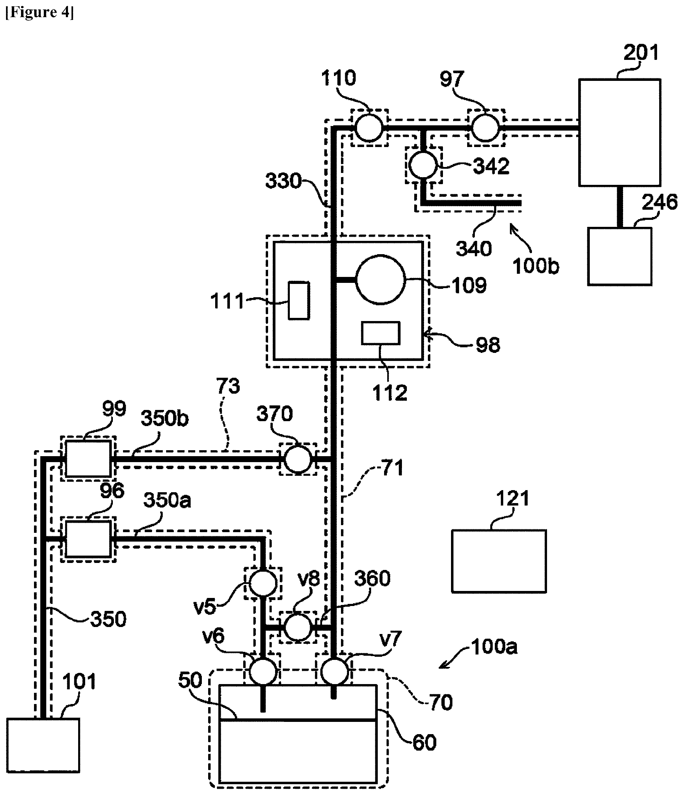

Although not shown in FIG. 4, a controller 121 is electrically connected to components such as the valves v1 to v4, the MFC 74, the MFC 84, the APC valve 243 and the vacuum pump 246 serving as the vacuum exhaust apparatus. The controller 121 controls such components such that a parameter (such as a flow rate of each gas supplied to the process chamber 201 and the inner pressure of the process chamber 201) is maintained at a predetermined value at a desired timing. In such an example, the MFCs 74a and 74b are collectively referred to as the "MFC 74", and the MFCs 84a and 84b are collectively referred to as the "MFC 84".

### <Gas Supply System>

The substrate processing apparatus 10 includes a gas supply system 100 shown in FIG. 4. The gas supply system 100 includes a gas supplier (which is a gas supply structure) 100a, an exhauster (which is an exhaust structure) 100b and the controller 121 described later.

### <Gas Supplier>

The gas supplier 100a is configured to supply the process gas containing the gas obtained by gasifying the material (that is, the gas obtained by converting the material into a gaseous state) to the process chamber 201. Specifically, the gas supplier 100a is configured to supply the process gas containing the gas (hereinafter, also referred to as the "precursor gas") obtained by sublimating a solid source material 50 to the process chamber 201 through the third gas supply pipe 330.

For example, in the gas supplier 100a according to the present embodiments, a carrier gas flow method is used. According to the carrier gas flow method, by heating a source material container 60 serving as a container capable of storing (containing) the solid source material 50 while supplying the carrier gas whose flow rate is controlled to the source material container 60, it is possible to generate the precursor gas by converting the solid source material 50 from a solid state into a gaseous state.

The gas supplier 100a includes a source gas supply line and a dilution gas supply line.

The source gas supply line is constituted mainly by the third gas supply pipe 330, an opening/closing valve 97, a supply valve 110, a concentration meter 98, a secondary valve v7, the source material container 60, an introduction pipe (inlet pipe) 350a serving as an introduction structure (inlet structure), a primary valve v6, an introduction valve (inlet valve) v5, an MFC 96. The source gas supply line may further include a carrier gas source 101 and the nozzle 430 connected to the third gas supply pipe 330.

The third gas supply pipe 330 is a pipe connecting the nozzle 430 and the source material container 60. The third gas supply pipe 330 may also be referred to a "secondary side pipe" of the source material container 60. The process gas is supplied to the process chamber 201 through the third gas supply pipe 330 and the nozzle 430.

The opening/closing valve 97 is provided at the third gas supply pipe 330, closest to the process chamber 201. Specifically, the opening/closing valve 97 is provided in the vicinity of a connecting location (connecting portion) between the third gas supply pipe 330 and the nozzle 430. The opening/closing valve 97 may also be referred to as a "final valve".

The supply valve 110 is provided at the third gas supply pipe 330 at an upstream side of the opening/closing valve 97.

The concentration meter 98 is provided at the third gas supply pipe 330 at an upstream side of the supply valve 110, and is configured to measure a concentration of the process gas flowing through the pipe. In the present embodiments, the concentration of the process gas may refer to a proportion (ratio) of the precursor gas contained in the process gas (that is, a gaseous mixture described later) supplied to the process chamber 201. Specifically, the concentration meter 98 is constituted by: a pressure sensor 109 configured to measure a total pressure of a gas (process gas); a temperature sensor 111 configured to measure a temperature of the gas; and an optical system 112 configured to measure an absorbance of the gas. That is, the concentration meter 98 is configured to calculate a concentration of the source gas (the concentration of the process gas) from measurement results related thereto.

Hereinafter, how the concentration meter 98 calculates the concentration will be described. The following Lambert equation ([Equation 1]) is known to represent a relationship between the absorbance and the concentration. $- ln \left(\frac{I}{{I}_{0}}\right) = {αLC}_{M}$

By transforming [Equation 1] using PV = nR₀T and C_{M} = n/V, it is possible to obtain the following equation ([Equation 2]). In such a manner, it is possible to perform a concentration conversion by transforming the three equations mentioned above. The concentration meter 98 calculates the concentration using the following equation ([Equation 2]). $C = \frac{{R}_{0} ⋅ T}{α ⋅ L ⋅ {P}_{T}} ln \frac{{I}_{0}}{I}$

In the equations mentioned above, "C" is the concentration, "α" is an absorption coefficient (m²), "L" is an optical path length (m), "T" is the absolute temperature (K), "P_{T}" is the total pressure (Pa), and "R₀" is the universal gas constant (= 8.314 (J/mol·k)).

The concentration meter 98 is provided at the third gas supply pipe 330 at a downstream side of a connecting location between the third gas supply pipe 330 and an introduction pipe (inlet pipe) 350b described later. The secondary valve v7 is provided at the third gas supply pipe 330 at an upstream side of the concentration meter 98. Specifically, the secondary valve v7 is provided at the third gas supply pipe 330 between the concentration meter 98 and the source material container 60, closer to the source material container 60. More specifically, the secondary valve v7 is provided in the vicinity of a connecting location between the third gas supply pipe 330 and the source material container 60.

The source material container 60 is configured to store (contain) a material (source material). As the material, for example, a solid source material that possesses low vapor pressure characteristics may be used. In the present specification, the term "vapor pressure" may refer to a pressure of a substance in the solid-gas equilibrium. In addition, the term "material that possesses low vapor pressure characteristics" may refer to a material whose pressure in the solid-gas equilibrium is lower than that of other materials. Therefore, in order to change (convert) the material that possesses low vapor pressure characteristics from a solid state to a gaseous state, as compared to other materials, it is preferable to use a condition of a higher temperature and a higher vacuum.

The introduction pipe 350a is a pipe connecting the source material container 60 and the carrier gas source 101. The introduction pipe 350a may also be referred to as a "primary side pipe" of the source material container 60. The carrier gas is introduced (supplied) from the carrier gas source 101 into the source material container 60 through the introduction pipe 350a.

The primary valve v6 is provided at the introduction pipe 350a, closest to the source material container 60. More specifically, the primary valve v6 is provided in the vicinity of a connecting location between the introduction pipe 350a and the source material container 60.

The introduction valve v5 is provided at the introduction pipe 350a at an upstream side of the primary valve v6.

The MFC 96 is provided at the introduction pipe 350a at an upstream side of the introduction valve v5. The MFC 96 is configured to adjust a flow rate of the carrier gas flowing through the introduction pipe 350a.

The carrier gas source 101 is configured to supply the carrier gas to the introduction pipe 350a and the introduction pipe 350b described later. As the carrier gas, for example, it is preferable to use an inert gas that does not react with the solid source material.

In addition, a bypass pipe 360 is provided so as to connect the introduction pipe 350a and the third gas supply pipe 330 without passing through the source material container 60. Specifically, the bypass pipe 360 is configured to connect a portion of the introduction pipe 350a between the introduction valve v5 and the primary valve v6 to a portion of the third gas supply pipe 330 between the concentration meter 98 and the secondary valve v7. A bypass valve v8 is provided at the bypass pipe 360. Thereby, it is possible to purge the third gas supply pipe 330 with the carrier gas without passing through the source material container 60. The gas supplier 100a may further include the bypass pipe 360 and the bypass valve v8.

The source material container 60 is surrounded by a subsidiary heater 70. The subsidiary heater 70 is configured to be capable of heating the solid source material 50 in the source material container 60 to a temperature equal to or greater than a temperature at which the solid source material 50 is converted into the gaseous state.

Temperatures of the third gas supply pipe 330, the opening/closing valve 97, the supply valve 110, the concentration meter 98, the secondary valve v7, the introduction pipe 350a, the primary valve v6, the introduction valve v5, the MFC 96, the bypass pipe 360, the bypass valve v8, an exhaust valve 342 and an exhaust pipe 340 are controlled by a pipe heater 71 such that the temperatures thereof are equal to or greater than the temperature at which the solid source material 50 is converted into the gaseous state. Such a temperature control by the pipe heater 71 is preferably performed at a temperature higher than a heating temperature for the source material container 60 by the subsidiary heater 70. The temperatures of the exhaust valve 342 and the exhaust pipe 340 may be controlled by a pipe heater different from the pipe heater 71.

The dilution gas supply line is constituted mainly the introduction pipe 350b, a valve 370 and an MFC 99, which serve as a dilution structure.

The introduction pipe 350b is a branch pipe branching off from the introduction pipe 350a, and is connected to the third gas supply pipe 330. Specifically, the introduction pipe 350b branches off from a portion of the introduction pipe 350a between the carrier gas source 101 and the MFC 96, and is connected to a portion of the third gas supply pipe 330 between the bypass pipe 360 and the concentration meter 98. The carrier gas from the carrier gas source 101 is introduced (supplied) to the third gas supply pipe 330 through the introduction pipe 350b without passing through the source material container 60. In addition, since the carrier gas flowing through the introduction pipe 350b dilutes the process gas containing the precursor gas obtained by sublimating the solid source material 50, in the present embodiments, the carrier gas may also be referred to as the "dilution gas". In addition, the process gas supplied to process chamber 201 is a gaseous mixture of the precursor gas (which is obtained by sublimating the solid source material 50), the carrier gas and the dilution gas. That is, according to the present embodiments, the process gas containing the precursor gas obtained by sublimating the solid source material 50 is diluted with the dilution gas to form a gaseous mixture gas of the precursor gas, the carrier gas and the dilution gas. Then, the process gas is supplied to the process chamber 201.

The valve 370 is provided at the introduction pipe 350b, in the vicinity of the third gas supply pipe 330. Specifically, the valve 370 is provided at the introduction pipe 350b, in the vicinity of the connecting location between the introduction pipe 350b and the third gas supply pipe 330.

The MFC 99 is provided at the introduction pipe 350b at an upstream side of the valve 370. Specifically, the MFC 99 is provided in the vicinity of a connecting location between the introduction pipe 350a and the introduction pipe 350b. The MFC 99 is configured to adjust a flow rate of the dilution gas flowing through the introduction pipe 350b.

Temperatures of the introduction pipe 350b, the valve 370 and MFC 99 are controlled by a pipe heater 73 such that the temperatures thereof are equal to or greater than the temperature at which the solid source material 50 is converted into the gaseous state. Such a temperature control by the pipe heater 73 is preferably performed at a temperature higher than the heating temperature for the source material container 60 by the subsidiary heater 70. For example, according to the present embodiments, the heating temperatures of the pipe heaters 71 and 73 are controlled to the same temperature. However, the heating temperature of the pipe heater 71 and the heating temperature of the pipe heater 73 may be different. In addition, the pipe heaters 71 and 73 may also be referred to as "subsidiary heaters 71 and 73".

The exhauster 100b is configured to exhaust the process gas containing the gas obtained by gasifying the material such that the process gas is exhausted without passing through the process chamber 201. Specifically, the exhauster 100b exhausts the process gas (that is, the gaseous mixture) containing the precursor gas obtained by sublimating the solid source material 50 through an upstream location (upstream side) of the opening/closing valve 97. The exhauster 100b includes the exhaust pipe 340 and the exhaust valve 342.

The exhaust pipe 340 is a pipe through which the process gas inside the third gas supply pipe 330 is exhausted. The exhaust pipe 340 branches off from a portion of the third gas supply pipe 330 between the opening/closing valve 97 and the supply valve 110. In addition, an end of the exhaust pipe 340 may be or may not be connected to a vacuum pump (not shown). The process gas inside the third gas supply pipe 330 is capable of being exhausted without connecting the vacuum pump to the end of the exhaust pipe 340 to create a negative pressure inside the exhaust pipe 340, because the carrier gas is pressure-fed from the carrier gas source 101.

The exhaust valve 342 is provided at the exhaust pipe 340. The exhaust valve 342 is provided at the exhaust pipe 340 in the vicinity of a location where the exhaust pipe 340 branches off from the third gas supply pipe 330.

Although not shown in FIG. 4, the controller 121 is electrically connected to the components such as the valves v5 to v8, the MFCs 96 and 99, the valve 370, the exhaust valve 342, the concentration meter 98, the subsidiary heater 70 and the pipe heaters 71 and 73. The controller 121 controls such components such that a parameter (such as the flow rate of each gas and a pressure related thereto) is maintained at a predetermined value at a desired timing.

### <Operation of Gas Supplier>

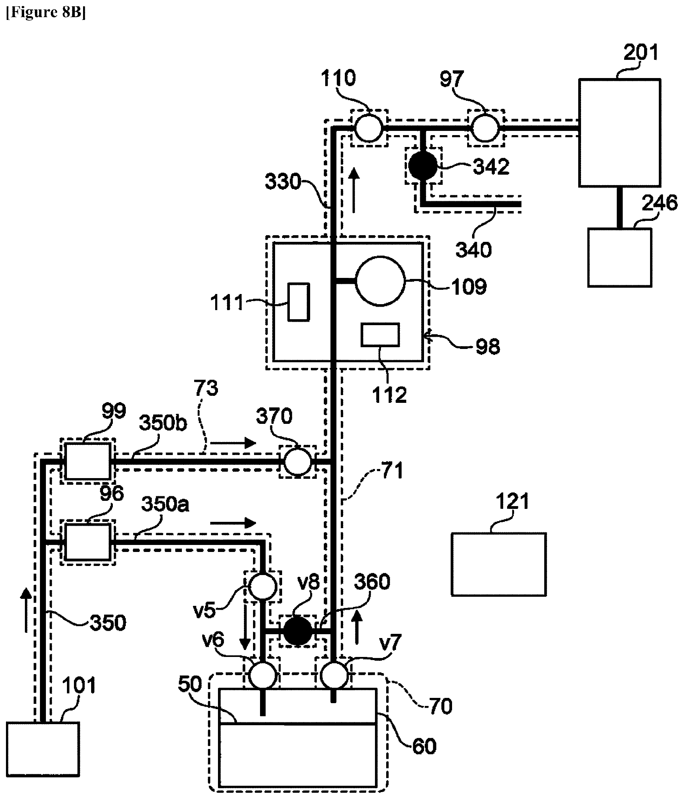

FIG. 8B is a diagram schematically illustrating a state when the process gas containing the precursor gas is supplied to the process chamber 201. In such a state, the bypass valve v8 and the exhaust valve 342 are closed, while the introduction valve v5, the primary valve v6, the secondary valve v7, the supply valve 110 and the opening/closing valve 97 are open. The valve 370 is also open. The controller 121 is configured to heat the solid source material 50 in the source material container 60 using the subsidiary heater 70, and to supply the gaseous mixture of the gas (which is obtained by sublimating the solid source material 50, that is, the precursor gas), the carrier gas and the dilution gas into the process chamber 201, while monitoring the concentration (flow rate) of the gaseous mixture using the concentration meter 98. In addition, the controller 121 is further configured to stop a supply of the precursor gas by closing the secondary valve v7. In such a state, a supply of the dilution gas may also be stopped by closing the valve 370.

### <Operation of Exhauster>

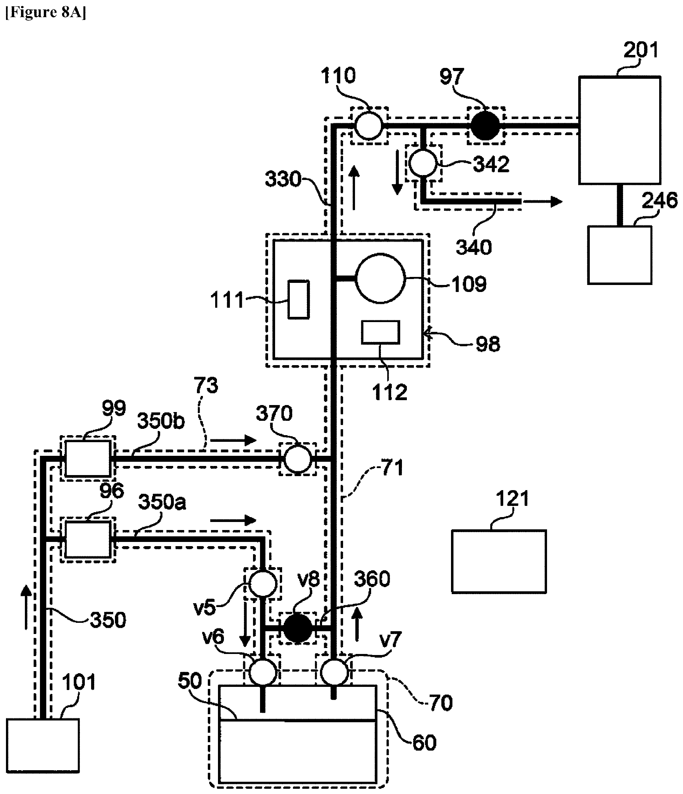

FIG. 8A is a diagram schematically illustrating a state when the process gas containing the precursor gas is exhausted without passing through the process chamber 201. In such a state, the bypass valve v8 and the opening/closing valve 97 are closed, while the introduction valve v5, the primary valve v6, the secondary valve v7, the supply valve 110 and the exhaust valve 342 are open. The controller 121 is configured to heat the solid source material 50 in the source material container 60 using the subsidiary heater 70, and to open the opening/closing valve 97 and close the exhaust valve 342 at a timing when a flow rate of the precursor gas reaches a saturated state by monitoring the concentration (flow rate) of the gaseous mixture of the gas (which is obtained by sublimating the solid source material 50, that is, the precursor gas), the carrier gas and the dilution gas using the concentration meter 98. In such a manner, the controller 121 is configured to switch an operation of the exhauster 100b to an operation of the gas supplier 100a. In the present specification, the term "saturated state" may refer to not merely a state in which the flow rate of the precursor gas is constant but a state in which the flow rates of both the carrier gas and the dilution gas are constant.

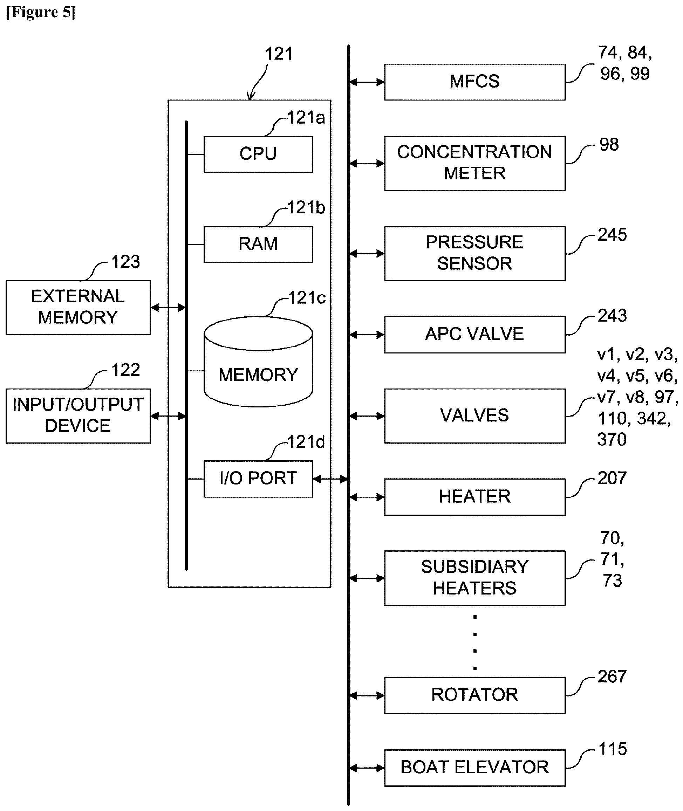

As shown in FIG. 5, the controller 121 serving as a control structure (control apparatus) is constituted by a computer including a CPU (Central Processing Unit) 121a, a RAM (Random Access Memory) 121b, a memory 121c and an I/O port (input/output port) 121d. The RAM 121b, the memory 121c and the I/O port 121d are configured to be capable of exchanging data with the CPU 121a through an internal bus. For example, an input/output device 122 constituted by a component such as a touch panel is connected to the controller 121.

For example, the memory 121c is configured by a component such as a flash memory and a hard disk drive (HDD). For example, a control program configured to control an operation of the substrate processing apparatus 10 or a process recipe containing information on procedures and conditions of the substrate processing described later may be readably stored in the memory 121c. The process recipe is obtained by combining steps (procedures) of the substrate processing described later such that the controller 121 can execute the steps to acquire a predetermined result, and functions as a program. Hereinafter, the process recipe and the control program may be collectively or individually referred to as a "program". Thus, in the present specification, the term "program" may refer to the process recipe alone, may refer to the control program alone or may refer to both of the process recipe and the control program. The RAM 121b functions as a memory area (work area) where a program or data read by the CPU 121a is temporarily stored.

The I/O port 121d is connected to components described above such as the MFCs 74, 84, 96 and 99, the concentration meter 98, the valves v1 to v8, 97, 110, 342 and 370, the APC valve 243, the pressure sensor 245, the vacuum pump 246, the heater 207, the subsidiary heater 70, the pipe heaters 71 and 73, the rotator 267 and the boat elevator 115.

The CPU 121a is configured to read the control program from the memory 121c and execute the control program read from the memory 121c. In addition, the CPU 121a is further configured to read the process recipe from the memory 121c, for example, in accordance with an operation command inputted from the input/output device 122. In accordance with contents of the process recipe read from the memory 121c, the CPU 121a is configured to be capable of controlling various operations such as flow rate adjusting operations for various gases by the MFCs mentioned above, opening and closing operations of the valves mentioned above, an opening and closing operation of the APC valve 243, a pressure adjusting operation by the APC valve 243 based on the pressure sensor 245, a temperature adjusting operation by the heater 207 based on the temperature sensor 263, a start and stop operation of the vacuum pump 246, an operation of adjusting a rotation and a rotation speed of the boat 217 by the rotator 267, an elevating and lowering operation of the boat 217 by the boat elevator 115. According to the present embodiments, the CPU 121a is further configured to be capable of controlling various operations such as operations of components constituting the gas supplier 100a and operations of components constituting the exhauster 100b.

For example, the controller 121 is not limited to a dedicated computer, and may be embodied by a general-purpose computer. For example, the controller 121 according to the present embodiments may be embodied by preparing an external memory 123 storing the program and by installing the program onto the general-purpose computer using the external memory 123. For example, the external memory 123 may include a magnetic tape, a magnetic disk such as a flexible disk and a hard disk, an optical disk such as a CD and a DVD, a magneto-optical disk such as an MO and a semiconductor memory such as a USB memory and a memory card. However, a method of providing the program to the computer is not limited to that using the external memory 123. For example, the program may be supplied to the computer (general-purpose computer) using a communication interface such as the Internet and a dedicated line without using the external memory 123. The memory 121c or the external memory 123 may be embodied by a non-transitory computer readable recording medium. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123.

### <Substrate Processing Method>

Hereinafter, an example of processing the wafer 200 will be described. More specifically, as a part of a manufacturing process of a semiconductor device, an example of forming a film on the wafer 200 will be described. First, the wafers 200 are transferred (charged) into the boat 217, and the boat 217 is transferred (loaded) into the process chamber 201. After the boat 217 is loaded into the process chamber 201, the inner pressure and the inner temperature of the process chamber 201 are adjusted. Then, the following four steps (that is, a film forming step #1, a film forming step #2, a film forming step #3 and a film forming step #4) are sequentially performed.

According to a processing (film forming process) of the present embodiments, the film such as an oxide film or a nitride film is formed on the wafer 200 by performing a cycle (film forming cycle) a predetermined number of times (once or more times). For example, the cycle may include: a step (film forming step #1) of supplying the process gas containing the precursor gas to the wafer 200 in the process chamber 201; a purge step (film forming step #2) of removing a residual gas from the process chamber 201; a step (film forming step #3) of supplying the reactive gas (such as the oxygen-containing gas and the nitrogen-containing gas) to the wafer 200 in the process chamber 201; and a purge step (film forming step #4) of removing the reactive gas (such as the oxygen-containing gas and the nitrogen-containing gas) (residual gas) from the process chamber 201. The steps in the cycle are performed non-simultaneously.

Hereinafter, each step (each film forming step) of the film forming process will be described in detail.

### <Film Forming Step #1>

The film forming step #1 may include the following steps (a) and (b). In the step (a), first, the process gas containing the precursor gas is exhausted without passing through the process chamber 201. Specifically, the opening/closing valve 97 and the bypass valve v8 are closed, while the exhaust valve 342, the supply valve 110, the secondary valve v7, the primary valve v6 and the introduction valve v5 are open. In addition, the valve 370 is open. Then, with the subsidiary heater 70 and the pipe heaters 71 and 73 in operation, the carrier gas whose flow rate is controlled by the MFC 96 is supplied into the source material container 60, and the process gas (which contains the precursor gas generated from the solid source material 50 in the source material container 60 and the carrier gas) is supplied to the third gas supply pipe 330. In addition, the dilution gas whose flow rate is controlled by the MFC 99 is supplied to the third gas supply pipe 330, and the dilution gas is mixed with the process gas containing the precursor gas and the carrier gas. For example, the dilution gas whose temperature is higher than that of the process gas may be mixed with the process gas. Then, the concentration of the process gas mixed with the dilution gas (that is, the process gas (gaseous mixture) containing the precursor gas, the carrier gas and the dilution gas) is measured by the concentration meter 98. While monitoring the concentration of the process gas using the concentration meter 98, the process gas is exhausted through the exhaust pipe 340 until the flow rate of the precursor gas reaches the saturated state.

Then, at a timing when the concentration (flow rate) of the process gas (precursor gas) measured by the concentration meter 98 reaches the saturated state, the processing switches from the step (a) to the step (b).

In the step (b), the opening/closing valve 97 is opened, and the exhaust valve 342 is closed. As a result, the process gas mixed with the dilution gas is supplied to the process chamber 201 through the third gas supply pipe 330. In the step (a) and the step (b), the source material container 60 and the third gas supply pipe 330 (that is, the pipe from the source material container 60 to the process chamber 201) are heated to a temperature above a sublimation temperature or an evaporation temperature of the material (source material).

### <Film Forming Step #2>

The film forming step #2 includes a step (c) of stopping a supply of the process gas to the process chamber 201. Specifically, in the step (c), at least the opening/closing valve 97 is closed to stop the supply of the process gas containing the precursor gas to the process chamber 201. More specifically, the secondary valve v7 and the valve 370 are closed. In addition, the supply valve 110 may also be closed. Further, the subsidiary heater 70, the pipe heaters 71 and 73 and the MFCs 96 and 99 are continuously operated (that is, remain in "ON" state) at least until the substrate processing is completed. In addition, during the film forming step #2, with the valve 243 of the exhaust pipe 231 open, and an atmosphere (inner atmosphere) of the process furnace 202 is exhausted such that a pressure (inner pressure) of the process furnace 202 reaches 20 Pa or less using the vacuum pump 246. Thereby, it is possible to remove a residual gas (residual gaseous mixture) from the process chamber 201. In such an operation, when supplying the inert gas (such as the N₂ gas serving as the carrier gas) to the process furnace 202, it is possible to improve an efficiency of removing the residual gas (residual source gas) from the process chamber 201.

### <Film Forming Step #3>

In the film forming step #3, the oxygen-containing gas serving as the reactive gas is supplied. Specifically, the valve v3 provided at the branch pipe 82a of the first gas supply pipe 310 is opened, and the valve v4 provided at the branch pipe 82b is closed. Thereby, the oxygen-containing gas whose flow rate is adjusted by the MFC 84a is supplied through the first gas supply pipe 310 to the process chamber 201 via the first gas supply holes 410a of the first nozzle 410, while being exhausted through the exhaust pipe 231. By supplying the oxygen-containing gas, a film (or a layer) on the wafer 200 reacts with the oxygen-containing gas. Thereby, it is possible to form the oxide film on the wafer 200.

When the nitrogen-containing gas serving as the reactive gas is supplied, the valve v1 provided at the branch pipe 72a of the second gas supply pipe 320 is opened, and the valve v2 provided at the branch pipe 72b is closed. Thereby, the nitrogen-containing gas whose flow rate is adjusted by the MFC 74a is supplied through the second gas supply pipe 320 to the process chamber 201 via the second gas supply holes 420a of the second nozzle 420, while being exhausted through the exhaust pipe 231. By supplying the nitrogen-containing gas, a film (or a layer) on the wafer 200 reacts with the nitrogen-containing gas. Thereby, it is possible to form the nitride film on the wafer 200. Similarly, when forming an oxynitride film, in the present step, as the reactive gas, the oxygen-containing gas is supplied through the first gas supply holes 410a of the first nozzle 410, and the nitride-containing gas is supplied through the second gas supply holes 420a of the second nozzle 420, as described above. For example, the oxygen-containing gas and the nitrogen-containing gas may be supplied simultaneously, or the oxygen-containing gas and the nitrogen-containing gas may be supplied separately.

### <Film Forming Step #4>

In the film forming step #4, after the oxide film is formed, at least the valve v3 is closed, and the inner atmosphere of the process chamber 201 is vacuum-exhausted using the vacuum pump 246 serving as the vacuum exhaust apparatus to remove the oxygen-containing gas (which contributed to the film formation) remaining in the process chamber 201. In such an operation, when supplying the inert gas (such as the N₂ gas serving as the carrier gas) to the process chamber 201, it is possible to improve an efficiency of removing the residual gas (residual oxygen-containing gas) from the process chamber 201.

By performing the cycle (which includes the film forming steps #1 to #4 mentioned above) a predetermined number of times, it is possible to form the oxide film of a predetermined thickness on the wafer 200. According to the present embodiments, for example, the cycle (that is, the film forming steps #1 to #4) are performed a plurality number of times.

In the present embodiments, the flow rate of the precursor gas when the step (a) is switched to the step (b) is set in advance such that the flow rate of the process gas supplied in the step (b) in the first execution of the cycle is equivalent to (that is, substantially equal to) the flow rate of the process gas supplied in the step (b) in the second or subsequent execution of the cycle. However, the technique of the present disclosure is not limited to such a configuration. For example, the flow rate of the precursor gas when switching from the step (a) to the step (b) may be less than the flow rate saturated in the step (b) in the first execution of the cycle, or may be greater than the flow rate saturated in the step (b) in the first execution of the cycle. For example, an operation of switching the step (a) to the step (b) may be performed only in the first execution of the cycle. In other words, in the second or subsequent execution of the cycle, the step (b) of the film forming step #1 and the film forming steps #2 to #4 may be repeatedly performed.

For example, it is preferable that the flow rate of the precursor gas from the second or subsequent execution of the cycle is set to be the same as the flow rate of the precursor gas at the end of the step (a) of the first execution of the cycle.

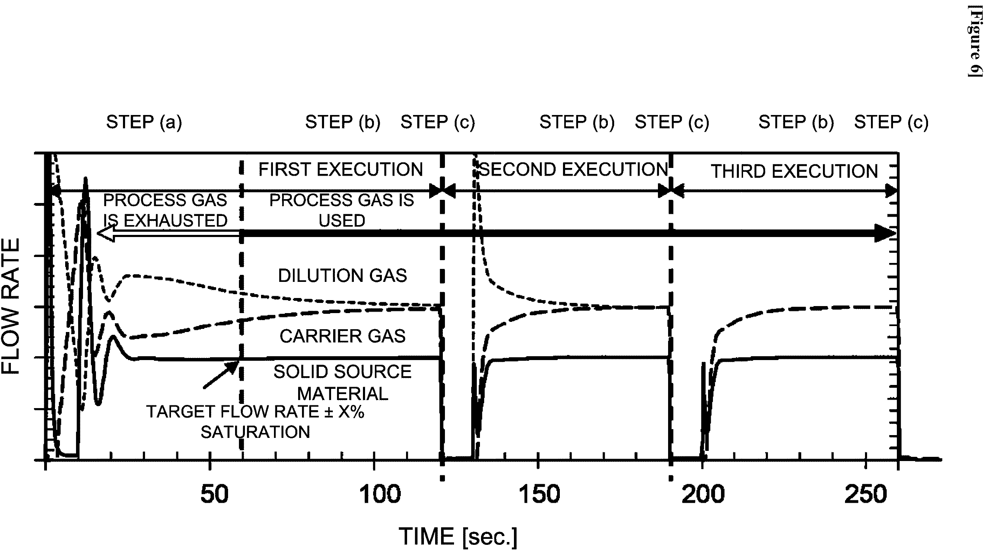

In addition, before the film forming step #1 is performed, a concentration SV of the precursor gas used to process the substrate (that is, the wafer 200) is set in the controller 121. In addition, the concentration SV may be input externally by a user, or may be set based on concentration information stored in a component such as the memory 121c. When the concentration SV is set, an output volume MV corresponding thereto is set. Then, the MFC 96 controls the flow rate of the carrier gas, and the MFC 99 controls the flow rate of the dilution gas. Then, a concentration PV of the process gas measured by the concentration meter 98 is output to the controller 121, and an output volume MV' is set. The flow rate of the gas is finally controlled such that the concentration SV becomes equal to the concentration PV. In such an operation, as shown in FIG. 6, the concentrations of the carrier gas, the dilution gas and the precursor gas approach constant values (stable states), respectively.

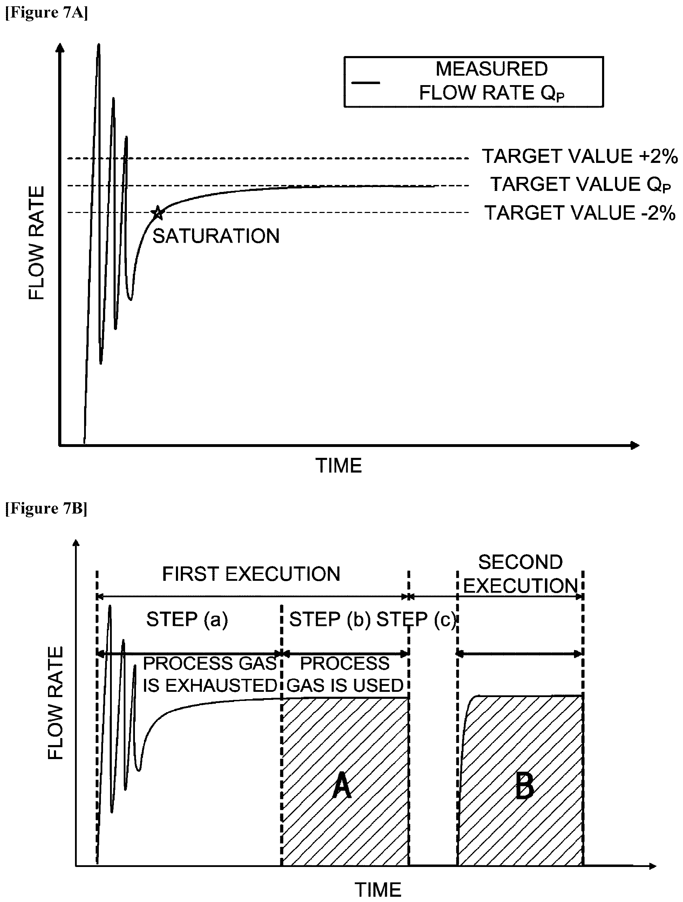

As shown in FIG. 6, in the first execution of the cycle, the flow rates of the gases are unstable, especially in an initial stage of the first execution. Therefore, according to the present embodiments, the process gas is discharged (exhausted) to the exhaust pipe 340 in the step (a) in the first execution of the cycle. Thus, a time (time duration) for performing the first execution tends to be longer than a time (time duration) for performing the second or subsequent execution. In FIG. 6, the precursor gas is indicated by a solid line, the carrier gas is indicated by a long-dashed line, and the dilution gas is indicated by a short-dashed line. In addition, in FIG. 6, "X" in the "TARGET FLOW RATE ± X%" indicates a value set in advance before referring to empirical data. FIG. 7A is a diagram schematically illustrating an example in which the flow rate of the precursor gas has converged to a target value (target flow rate). FIG. 7B is a diagram schematically illustrating an example in which the flow rate of the process gas supplied to the process chamber 201 is substantially the same in the first and second executions.

Also, in FIG. 6, a time (timing) at which the precursor gas reaches the saturated state is indicated by a thick-dashed line. It is preferable that a supply time of the process gas in the first execution is set to be equal to a supply time of the process gas in the second or subsequent execution (60 seconds in FIG. 6) (that is, an area "A" is set to be equal to an area "B" shown in FIG. 7B). The thick-dashed lines of the first execution correspond to a time (time duration) of performing the film forming step #1 in the process recipe. On the other hand, by changing (adjusting) the time of performing the film forming step #1 in the first execution of the cycle of the process recipe each time, it is possible to approach a state shown in FIG. 7B, that is, it is possible to set the area A to be equal to the area B.

In FIGS. 6 and 7A, the step (a), the step (b) and the step (c) are shown. When the flow rate of the precursor gas reaches the saturated state, the processing switches from the step (a) to the step (b). In addition, after that switching, the step (b) and the step (c) are repeatedly performed.

After the film forming process mentioned above is completed, the inner pressure of the process chamber 201 is returned to the normal pressure (atmospheric pressure). Specifically, for example, the inert gas such as the N₂ gas is supplied to the process chamber 201 and then exhausted. Thereby, the inner atmosphere of the process chamber 201 is purged with the inert gas, and a substance such as the gas remaining in the process chamber 201 is removed from the process chamber 201 (purge by the inert gas). Thereafter, the inner atmosphere of the process chamber 201 is replaced with the inert gas (substitution by the inert gas), and the inner pressure of the process chamber 201 is returned to the normal pressure (atmospheric pressure). Then, the wafers 200 are discharged (unloaded) from the process chamber 201. Thereby, the substrate processing according to the present embodiments is completed.

According to the present embodiments, it is possible to obtain one or more of the effects described below.

According to the present embodiments, first, the process gas containing the precursor gas is exhausted from the source material container 60 without passing through the process chamber 201. When the flow rate of the precursor gas reaches the saturated state, the process gas containing the precursor gas is then supplied to the process chamber 201. As a result, it is possible to stably supply the precursor gas at a constant flow rate (or constant concentration) to the process chamber 201 without performing a flow rate control using the MFC. Since an amount of the precursor gas exhausted as described above can be maintained at an optimal level, it is possible to prevent an unnecessary consumption of the solid source material (which is expensive).

In addition, according to the present embodiments, when a threshold value (of, for example, a flow rate) set in advance is reached, the operation is switched from an exhaust of the process gas containing the precursor gas to a supply of the process gas to the process chamber. As a result, it is possible to continuously and stably supply the precursor gas to the process chamber 201 without performing the flow rate control using the MFC. By setting the threshold value in a manner described above, it is possible to stably supply the precursor gas at the constant flow rate to the process chamber 201 in each execution mentioned above.

In addition, according to the present embodiments, by using the pipe heaters 71 and 73, it is possible to suppress the re-solidification of the precursor gas (or the re-liquefaction in a case of the liquid source material) within the source material container 60 and in the third gas supply pipe 330 extending from the source material container 60 to the process chamber 201.

In addition, according to the present embodiments, since the carrier gas flow method is applied, even when a material (whose vapor pressure is too low to perform the flow rate control using the MFC) is used, it is possible to adjust the flow rate (concentration) of the precursor gas supplied to the process chamber 201.

In addition, according to the present embodiments, it is possible to adjust the concentration of the precursor gas contained in the process gas while suppressing the re-solidification of the precursor gas (or the re-liquefaction in the case of the liquid source material) contained in the process gas. As a result, it is possible to continuously and stably supply the precursor gas to the process chamber 201 without performing the flow rate control using the MFC.

In addition, according to the present embodiments, by performing a flow rate control using the carrier gas and the dilution gas, it is possible to stably supply the precursor gas (which is contained in the gaseous mixture serving as the process gas) at a constant concentration.

In addition, according to the present embodiments, it is possible to exhaust the precursor gas through the third gas supply pipe 330 to the exhaust pipe 340 when the flow rate of the precursor gas is in an unstable state (for example, a vibration state) at a start of the supply of the precursor gas. As a result, it is possible to stably supply the precursor gas at the constant concentration to the process chamber 201.

In addition, according to the present embodiments, a solid source material containing a plurality of metal elements may be supplied to the process chamber 201 through the third gas supply pipe 330. For example, a metal source material (which contains a metal element and free of carbon (C)), that is, a source material serving as an inorganic metal source material (inorganic metal compound) and also serving as a halogen-based source material (also referred to as a "halide source material") may be used. In addition, according to the present embodiments, the third gas supply pipe 330 is included in the gas supply system 100 configured to be capable of supplying the precursor gas (which is obtained by gasifying the source material containing the plurality of metal elements) to the process chamber 201. Specifically, as the solid source material 50, for example, a molybdenum (Mo)-containing material may be used. As the molybdenum (Mo)-containing material, for example, a gas such as MoCl₅ gas, MoO₂Cl₂ gas and MoOCl₄ gas may be used.

As the carrier gas and the dilution gas used in the embodiments mentioned above, for example, the N₂ gas may be used. However, the technique of the present disclosure is not limited thereto. As the carrier gas and the dilution gas, for example, a rare gas such as argon (Ar) gas, helium (He) gas, neon (Ne) gas and xenon (Xe) gas may be used. For example, a dilution gas source may be provided separately from the carrier gas source 101. In such a case, the dilution gas may be different from the carrier gas.

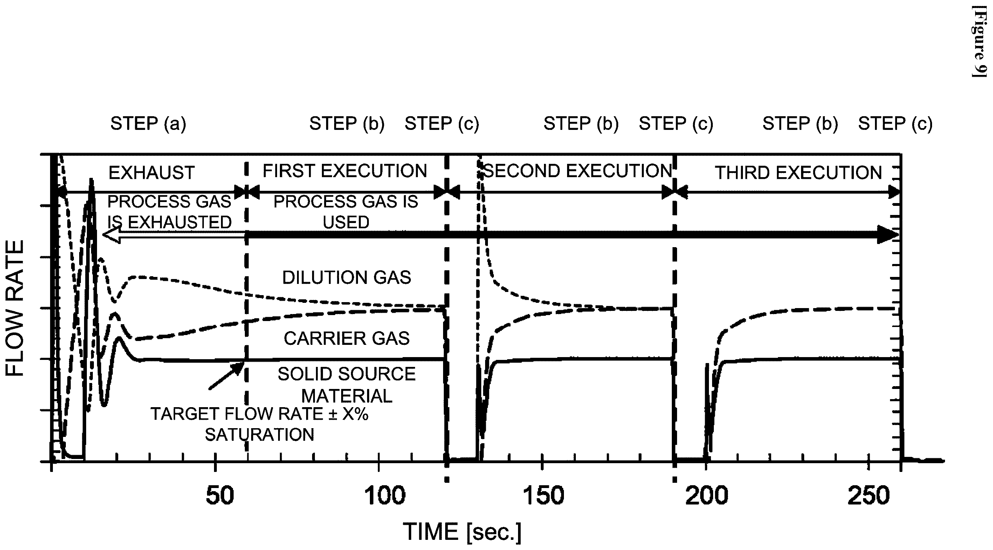

For example, according to the embodiments mentioned above, as shown in FIG. 6, in the first execution of the cycle, the step (a) and the step (b) are performed. However, the technique of the present disclosure is not limited thereto. As shown in FIG. 9, the step (a) may be performed until a dashed line (that is, a line indicating the saturated state) is reached in FIG. 7A, and in a first execution of a cycle shown in FIG. 9, the step (b) may be performed without performing the step (a). In the first and subsequent executions of the cycle shown in FIG. 9, the step (b) and the step (c) are repeatedly performed. Alternatively, after an entirety of the process gas generated in the first execution shown in FIG. 7B is completely exhausted, the step (b) and the step (c) are repeatedly performed in the first and subsequent executions shown in FIG. 9.

The invention may be summarized as follows: It is possible to stably supply a gas obtained by gasifying a material to a process chamber. There is provided a technique that includes: (a) exhausting a process gas containing a specified gas obtained by gasifying a material stored in a container such that the process gas is exhausted without passing through a process chamber; and (b) supplying the process gas to the process chamber, wherein a cycle comprising at least (b) is performed a plurality of times, and wherein, in a first execution of the cycle, (b) is performed by switching from (a) when a flow rate of the specified gas reaches a saturated state.

The technique of the present disclosure is described in detail by way of the embodiments mentioned above. However, the technique of the present disclosure is not limited thereto. The technique of the present disclosure may be modified in various ways without departing from the scope thereof. For example, the embodiments mentioned above are described by way of an example in which the film forming process for the semiconductor device is performed by the substrate processing apparatus. However, the technique of the present disclosure is not limited thereto. That is, the technique of the present disclosure may be applied not only to the film forming process mentioned above but also to other film forming processes of forming other films such as an oxide film, a nitride film or a film containing a metal. In addition, the specific contents of the film forming process are not limited to those exemplified in the embodiments mentioned above. For example, in addition to or instead of the film forming process mentioned above, the technique of the present disclosure may also be applied to a substrate processing such as an annealing process, an oxidation process, a nitridation process, a diffusion process and a lithography process.

In addition, the technique of the present disclosure may also be applied to other substrate processing apparatuses such as an annealing apparatus, an oxidation apparatus, a nitridation apparatus, an exposure apparatus, a coating apparatus, a drying apparatus, a heating apparatus, and a processing apparatus using a plasma. For example, the technique of the present disclosure may also be applied when a combination of such substrate processing apparatuses is provided.

For example, the embodiments mentioned above are described by way of an example in which the manufacturing process of the semiconductor device is performed. However, the technique of the present disclosure is not limited thereto. For example, the technique of the present disclosure may also be applied to various substrate processings such as a manufacturing process of a liquid crystal device, a manufacturing process of a solar cell, a manufacturing process of a light emitting device, a processing of a glass substrate, a processing of a ceramic substrate and a processing of a conductive substrate.

For example, the technique of the present disclosure may also be applied when a constituent of one of the embodiments mentioned above is substituted with another constituent of another embodiment, or when a constituent of one of the embodiments mentioned above is added to another embodiment. In addition, the technique of the present disclosure may also be applied when the constituent of the embodiments mentioned above is omitted or substituted, or when a constituent is added to the embodiments mentioned above.

### [Description of Reference Numerals]

50: Source material (an example of a material)
60: Source material container (an example of a container)

## Claims

1. A gas supply method comprising:
(a) exhausting a process gas containing a specified gas obtained by gasifying a material stored in a container such that the process gas is exhausted without passing through a process chamber; and
(b) supplying the process gas to the process chamber,
wherein a cycle comprising at least (b) is performed a plurality of times, and
wherein, in a first execution of the cycle, (b) is performed by switching from (a) when a flow rate of the specified gas reaches a saturated state.

2. The gas supply method of claim 1, wherein the flow rate of the specified gas when (a) is switched to (b) is set in advance such that a flow rate of the process gas supplied in (b) in the first execution of the cycle is equivalent to the flow rate of the process gas supplied in (b) in a second or subsequent execution of the cycle.

3. The gas supply method of claim 1 and/or 2, wherein the flow rate of the specified gas when (a) is switched to (b) is set to be less than the flow rate of the specified gas saturated in (b) in the first execution of the cycle.

4. The gas supply method of any one or more of claims 1 to 3, wherein the flow rate of the specified gas when (a) is switched to (b) is set to be greater than the flow rate of the specified gas saturated in (b) in the first execution of the cycle.

5. The gas supply method of any one or more of claims 1 to 4, wherein (b) is performed by switching from (a) in the first execution of the cycle but not in a second or subsequent execution of the cycle.

6. The gas supply method of any one or more of claims 1 to 5, wherein the cycle further comprises (c) stopping a supply of the process gas to the process chamber, and
wherein (b) and (c) are repeatedly performed in each execution of the cycle.

7. The gas supply method of any one or more of claims 1 to 6, wherein the flow rate of the specified gas in a second or subsequent execution of the cycle is set to be equal to the flow rate of the specified gas at an end of (a) in the first execution of the cycle.

8. The gas supply method of any one or more of claims 1 to 7, wherein a concentration meter is provided at a secondary pipe of the container, and
wherein, in (a) and (b), a concentration of the specified gas contained in the process gas is measured by the concentration meter.

9. The gas supply method of claim 8, wherein a dilution structure through which a dilution gas is supplied is connected to the secondary pipe of the container, and
wherein the concentration meter is provided at the secondary pipe downstream of a location connected with the dilution structure.

10. The gas supply method of claim 9, wherein the process gas is a gaseous mixture containing a carrier gas, the specified gas and the dilution gas, and
a concentration of the process gas measured by the concentration meter is a proportion of the specified gas contained in the gaseous mixture.

11. The gas supply method of any one or more of claims 1 to 10, wherein an exhaust pipe branching off from a pipe from the container to the process chamber is provided downstream of the pipe, and
wherein, in (a), the specified gas is exhausted through the pipe via the exhaust pipe.

12. A method of manufacturing a semiconductor device, comprising
processing a substrate accommodated in the process chamber by supplying the process gas into the process chamber using the gas supply method of any one or more of claims 1 to 11.

13. A gas supply system comprising
a controller configured to be capable of performing the gas supply method of any one or more of claims 1 to 11.

14. A substrate processing apparatus comprising:
a controller configured to be capable of processing a substrate accommodated in the process chamber by supplying the process gas into the process chamber using the gas supply system of claim 13.

15. A program that causes the substrate processing apparatus of claim 14, by a computer, to perform:
(a) exhausting a process gas containing a specified gas obtained by gasifying a material stored in a container such that the process gas is exhausted without passing through a process chamber;
(b) supplying the process gas to the process chamber; and
(c) performing (b) by switching from (a) when a flow rate of the specified gas reaches a saturated state in a first execution of a cycle comprising at least (b), wherein the cycle is performed a plurality of times.
